# EUROPEAN PATENT APPLICATION

(11) **EP 4 280 825 A1**
(43) Date of publication of application: **22.11.2023**
(21) Application number: 22174364.4
(22) Date of filing: 19.05.2022
(51) Int. Cl.: H05K 1/02, H05K 1/03, H05K 1/18, H05K 3/46

(54) **RF FRONT-END FUNCTIONALITY INTEGRATED IN A COMPONENT CARRIER STACK**

(71) Applicant: AT & S Austria Technologie & Systemtechnik Aktiengesellschaft, 8700 Leoben-Hinterberg (AT)
(72) Inventor: Lenhardt, Patrick, 8724 Spielberg (AT)
(74) Representative: Dilg, Haeusler, Schindelmann Patentanwaltsgesellschaft mbH

(57) **Abstract**

There is described a radio frequency, RF, module (100), comprising:
i) a stack (101) comprising at least one electrically conductive layer structure (104) and/or at least one electrically insulating layer structure (102); and
ii) a RF front-end functionality (115) that is integrated in the stack (101). Further, an RF arrangement, a manufacture method and a use are described.

## Description

### Field of the Invention

The invention relates to a radio frequency (RF) module that comprises a stack and a RF front-end functionality at least partially in the stack. Further, the invention relates to a method of manufacturing the RF module. The invention also relates to a use of a component carrier (in particular a printed circuit board or an IC substrate) as a fully functional RF front-end module.

Thus, the invention may relate to the technical field of component carriers such as printed circuit boards and IC substrates, in particular in the context of signal transmission.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically and magnetically reliable so as to be operable even under harsh conditions.

In particular, providing a component carrier with electromagnetic functionalities (e.g. antenna or radar functionalities) in a compact (robust) but still design flexible manner remains a challenge.

Devices with radio connectivity, such as smartphones, comprise a "front end" circuitry, which is in principle the plurality of devices configured to receive and send signals and enables the handling of signals from antenna to a subsequent processor. Conventionally, the front-end is formed by providing the individual discrete components (e.g. filter, amplifier, switches, etc.) and mounting them on a main board, e.g. as a module. Such a front-end module may be configured as a multi-die package (also called SiP (system-in-package)) including for example filters, switches, duplexers, mulitplexers, power amplifiers, converters (ADC/DAC), and others. Front-ends can be categorized according to their frequency band, e.g. high band, mid band, and low band module. The more frequency bands a device supports, the more modules are needed.

Nevertheless, externally assembled front-end modules may suffer from a non-optimal transition of an electromagnetic signals. Furthermore, a surface-mounted component increases the height of the overall system, which may be a major issue especially in the mobile handheld devices industry. Miniaturization not only in x, y (length, width) direction but also z (height) direction may be considered an important trend in the mobile industry.

Hence, in the light of the prior art, while size of the component carrier and manufacture costs should be kept low, signal transmission quality should be improved.

### Summary of the Invention

There may be a need to provide an RF front-end functionality in an efficient and compact (in particular a low height) manner. An RF module, a manufacture method, and a use are provided.

According to a first aspect of the invention, there is described a radio frequency (RF) module (e.g. configured as a component carrier), comprising:
i) a (component carrier layer) stack comprising at least one electrically conductive layer structure and/or at least one electrically insulating layer structure; and
ii) a (fully-functional) RF front-end functionality that is integrated (i.e. partially embedded and/or partially surface mounted, in other words: at least partially embedded) in the stack (e.g. some front-end sub-functionalities are embedded in the stack, while others are surface-mounted to the stack).

According to a further aspect of the invention, there is described a method of manufacturing a radio frequency module (in particular as described above), the method comprising:
i) forming a stack comprising at least one electrically conductive layer structure and/or at least one electrically insulating layer structure; and
ii) at least partially embedding a fully functional RF front-end functionality into the stack (i.e. integrating the RF front-end functionality in the stack).

According to a further aspect of the invention, there is described a use (method of using) a component carrier, in particular a printed circuit board or an IC substrate, as a fully functional RF front-end module.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In an embodiment, the component carrier comprises a (layer) stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

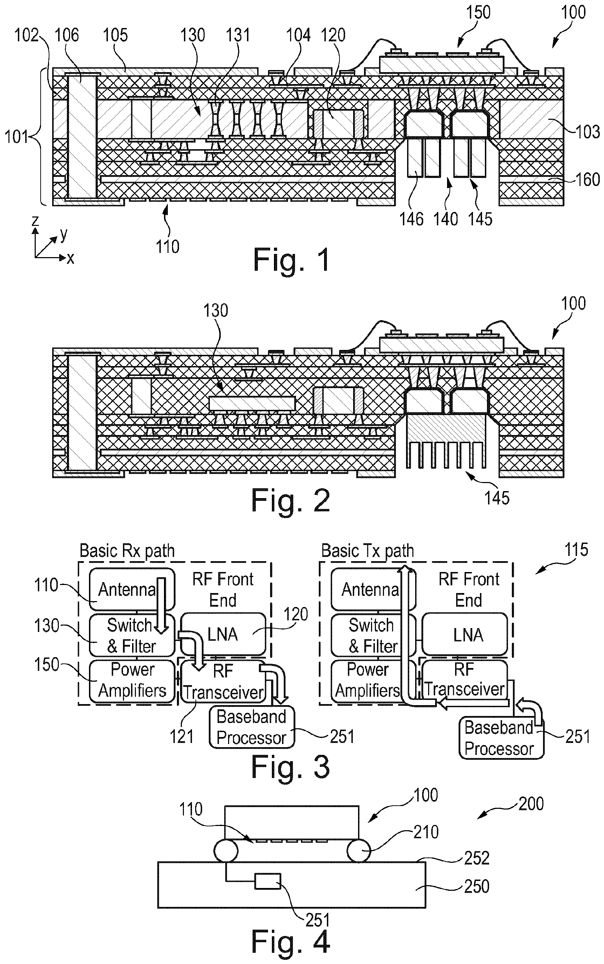

In the context of the present document, the term "RF front-end functionality" may in particular refer to a plurality of functionalities that are related to the reception and/or transmission of RF signals. The RF front-end may further refer to a plurality of functionalities/devices that relate to a processing of signals between an antenna and a processor. The plurality of functionalities may be summarized as the front-end functionality. In a further definition, an RF front-end comprises all components/circuitry between antenna (eventually including the antenna) up to and including (or not) a mixer stage (a mixer stage may mix e.g. the outputs of an amplifier and a (local) oscillator). In another definition, the RF front-end comprises the components/circuitry that process a signal at the original (RF) frequency before it is converted to another (lower) frequency. An exemplary example of a front-end functionality is given in Figure 3, wherein a receiver path and a transmitter path are illustrated. The front-end functionality in this example includes the antenna functionality and the further functionalities arranged between antenna and signal processor (baseband processor), e.g. switch, filter, amplifier, power amplifier, and LNA. A transceiver (or receiver and transmitter) functionality may be directly connected to the RF front-end but may not form part of it.

In a preferred embodiment, the front-end functionality is fully functional, so that all signal transmission/processing to be done by a front-end may be handled by the RF module. Thereby, a fully functional RF front-end module may be completely implemented in a (component carrier) stack.

In the context of the present document, the term "integrated" may in particular refer to the circumstance that a front-end functionality as described above is assembled to a (layer) stack. The front-end functionalities may be at least partially embedded in the stack and/or at least partially surface-mounted to the stack. In a specific example, the whole front-end functionality (in particular except the antenna), is embedded in the stack. In a further example, at least some of the front-end functionalities are directly surface mounted on a main surface of the stack. In a further embodiment, all RF front-end functionalities except the antenna and the power amplifier/module are embedded in the stack.

According to an exemplary embodiment, the invention may be based on the idea that a (fully functional) RF front-end functionality can be provided in an efficient and compact (in particular a low height) manner, when the front-end is integrated into the layer stack of a component carrier, such as a PCB or an IC substrate, turning the later into an RF front-end module. Such an RF module may be very design flexible and especially compact and robust. While the module may be used as a stand-alone product, it may also be coupled with a further device, e.g. a further component carrier such as a main board. The compact and robust RF module may thus be applied in a large variety of application, depending on the technical circumstances. Known and established manufacture processes from the component carrier industry may be applied in a straightforward manner to produce the integrated RF module.

While conventionally, the discrete devices of a front-end have been surface mounted to other devices, it has been found by the inventors that the whole front-end functionality may be integrated into a stack, thereby forming a reliable and compact module.

### Exemplary Embodiments

According to an embodiment, the RF module is configured as a printed circuit board, PCB, or as an integrated circuit, IC, substrate. In this manner, an established and industry-relevant component carrier technology can be directly applied to provide an efficient and robust RF module. The RF front-end functionalities may be completely or partially embedded in the component carrier. Preferably, the whole RF front-end functionality is implemented in the PCB or IC substrate so that, using established manufacture processes, a design-flexible and versatile usable module can be obtained.

In this context, the term "IC substrate" may in particular refer to a small high-density PCB (i.e. comprising comparable materials). An IC substrate may also be termed a chip-size PCB (or high density PCB), wherein the term "chip-size" may refer to the circumstance that the IC substrate comprises along the x-y plane a size that is comparable to the size of an electronic component (in particular an IC chip) that is placed in the z direction on the IC substrate. Hereby, the IC substrate size may be exactly the same, slightly smaller, or slightly larger than said electronic component. In an example, size difference (extension in the x-y plane) between IC and IC substrate size may be 75% or lower, in particular 50% or lower, more in particular 25% or lower.

According to a further embodiment, the RF front-end functionality comprises at least (one or) two of:
A filter functionality (filter device): a filter, such as a band-pass filter, may reduce noise and remove interfering signals from the desired signals. Out-of-band signals may be removed. In an embodiment, the filter functionality can be implemented by a filter component, e.g. embedded in the stack. In a more advanced example, the filter may be realized by a plurality of electrically conductive vias that are embedded in a glass substrate.

An analog-to-digital conversion functionality, e.g. realized as an analog-digital-converter (ADC), may convert an analog input signal to a digital signal that is then further processed, e.g. by a digital filter. In an example, the ADC is arranged in the receiver path after the mixer functionality. In this case, the RF front-end may end after the ADC. In another example, the ADC may be defined as the last component (in the receiver path) of the RF front-end. In an example, where the incoming signal is directly digitized by an ADC after filtering, the ADC may be defined or may not be defined as the last component of the RF front-end in the receiver path.

An antenna functionality: an antenna structure, e.g. a patch antenna, may be seen as part of the RF front-end. The antenna may receive or transmit an RF signal at/from the RF module. The antenna structure may be arranged at a main surface of the RF module. In an embodiment, the antenna structure can be manufactured using PCB processes such as providing a copper layer (e.g. by plating) and patterning the copper layer to obtain the antenna structure, e.g. by etching.

A switching functionality may be configured to provide different paths through the RF frond-end. In an example, a switching device may be configured to switch between a receiver path (e.g. with an LNA) and a transmitter path (e.g. with a power amplifier).

The RF front-end may be configured to fulfill a receiver functionality and/or a transmitter functionality (transceiver functionality), in a receiver/transceiver path.

An amplification functionality: an amplifier device may be configured to increase the sensitivity of the receiver by amplifying weak signals without contaminating them with noise, so that they can stay above the noise level in succeeding stages. In the receiver path, a low-noise amplifier (LNA) may be used. A power amplification may be used to increase the magnitude of power of a given signal. The power of the signal is increased to a level high enough to drive loads of output devices like RF transmitters, etc.

An oscillator functionality: a (local) oscillator may generate a radio frequency signal with an offset with respect to the incoming signal. The incoming signal and the oscillator signal may be mixed at a mixer functionality.

A mixer functionality: a mixer may mix the incoming signal with the signal from the oscillator to convert the signal to the intermediate frequency. The mixer (or an ADC after the mixer) may be seen as the last part of the RF front-end (in the receiver path). The mixer stage may include at least one of a voltage controlled oscillator (VCO), a phase locked loop (PLL), a low pass filter (LPF).

In one example, the oscillator functionality and/or the mixer functionality may be interpreted as part of the RF front-end. In another example, the oscillator functionality and/or the mixer functionality may not be interpreted as part of the RF front-end.

According to an exemplary example, it has been surprisingly found that a plurality of RF front-end functionalities can be efficiently integrated in one component carrier-based module.

According to a further embodiment, the RF front-end functionality further comprises an antenna structure assembled, in particular surface mounted and/or embedded, at an outer surface, in particular an outer main surface, of the stack. This may provide the advantage that the antenna may be directly integrated with the RF module at the stack. Preferably, the antenna structure may be manufactured in a PCB manufacture process together with the stack.

In the context of the present document, the term "antenna" may particularly denote an element connected for instance through a transmission line to a receiver or transmitter. Hence, an antenna may be denoted as an electrical member which converts electric power into radio waves, and/or *vice versa.* An antenna may be used with a controller (for instance a control chip) such as a radio transmitter and/or radio receiver. In transmission, a radio transmitter may supply an electric current oscillating at radio frequency (i.e. a high frequency alternating current) to the antenna, and the antenna may radiate the energy from the current as electromagnetic waves (in particular radio waves). In a reception mode, an antenna may intercept some of the power of an electromagnetic wave in order to provide a small voltage, that may be applied for example to a receiver to be amplified. In embodiments, the antenna may be configured as a receiver antenna, a transmitter antenna, or as a transceiver (i.e. transmitter and receiver) antenna. In an embodiment, the antenna structure may be used for a radar application. In one example, the antenna may be configured as a single antenna. In another example, the antenna may be configured as an (adhered, embedded) antenna array.

According to a further embodiment, the antenna structure is configured as at least one of a patch antenna, a microstrip antenna, a slot antenna. Thereby, a compact architecture with very low extension along the vertical direction (z) may be provided. In a specific example, the antenna may be configured as a dielectric resonator antenna (DRA), e.g. arranged in a cavity of the stack (slot antenna). Hereby, the DRA may be arranged directly on an electrically insulating layer structure or an electrically conductive layer structure of the stack. Further, an insulating material may be arranged between stack and DRA. In the later case, the DRA may be capacitively or inductively coupled with an electrically conductive layer structure (transmission line).

According to a further embodiment, the RF module further comprises an electromagnetic radiation shielding layer structure embedded in the stack (in particular below the antenna structure (wherein below means an overlap in the vertical direction, i.e. along the stack thickness), and configured to shield electromagnetic radiation with respect to the antenna structure. Such a shielding layer structure may efficiently protect embedded components in the stack from radiation associated with the antenna structure. Thereby, the reliability of the RF front-end module may be significantly improved. This may provide the advantage that an efficient shielding against electromagnetic radiation can be provided in a cost-efficient and robust manner.

In the context of the present document, the term "shielding structure" may refer to a structure which is configured for shielding electromagnetic radiation from propagating between two different entities, for example an antenna and another portion of the component carrier such as an (embedded) electronic component. Hence, the electromagnetic radiation shielding structure may prevent undesired crosstalk of electromagnetic radiation between the antenna on the one hand, and at least one component (which may for instance be embedded in the component carrier) and/or an electronic environment of the component carrier and/or another antenna of the component carrier on the other hand. The shielding structure is preferably made of an electrically conductive material, e.g. a metal, in particular copper and/or a metal-based surface finish.

According to a further embodiment, the electromagnetic radiation shielding layer structure comprises a magnetic material, in particular a ferrite material. A magnetic material may provide specific advantageous properties for the shielding functionality.

According to an embodiment, the magnetic material comprises at least one material of the group consisting of a ferromagnetic material (e.g. iron, nickel), a ferrimagnetic material, a permanent magnetic material, a soft magnetic material, a ferrite, a metal oxide (e.g. magnetite), a dielectric matrix (e.g. a resin), in particular a prepreg (or resin sheet), with magnetic particles therein, and an alloy, in particular an iron alloy or alloyed silicon, more in particular wherein the metallic particles comprise at least one of the group consisting of ferrite, a 3d material, and a 4f material. Thereby, established materials can be directly applied to manufacture the magnetic matrix in a cost-efficient manner.

A permanent magnetic material may be ferromagnetic material or ferrimagnetic material, and may for instance be provided on the basis of transition metals (with partially filled 3d shell) such as iron or nickel, or on the basis of rare earths (with partially filled 4f shell).

A soft magnetic material may be a material which can be easily re-magnetized, i.e. having a small area of its hysteresis curve. In other words, soft magnetic materials are those materials that are easily magnetized and demagnetized. They may have intrinsic coercivity less than 1000 Am-1.

A ferrite may be denoted as a type of ceramic compound composed of Fe₂O₃ combined chemically with one or more additional metallic elements. Ferrites are both electrically non-conductive and ferrimagnetic, so they can be magnetized or attracted by a magnet. Ferrites may be implemented as hard ferrites or soft ferrites, depending on the application.

According to a further embodiment, the RF module further comprises a cavity in the stack. Such a cavity may be a versatile space for accommodating a component. The cavity may be formed by cutting out a portion of the stack. In an example, a release layer can be embedded in the stack during build-up. Then, holes are drilled down to the release layer, so that the portion above the release layer may be removed easily. In an example, the cavity may extend from the main surface to a central core layer structure of the RF module. In a further example, the cavity may be provided by etching, drilling, or photolithography.

According to a further embodiment, the RF module further comprises a thermal device (in particular a heat sink). In particular, the thermal device is arranged/placed in the cavity (in particular completely arranged in the cavity), and configured to dissipate heat from at least a part of the RF front-end functionality. This may provide the advantage that the height in the vertical (z) direction may be reduced. Thereby, a more compact and robust RF module may be obtained. A thermal device such as a heat sink may be large in comparison to electronic components. Conventionally, such a thermal device is surface-mounted to a stack, thereby enormously increasing the height of a package. By placing the thermal device at least partially (preferably fully) in a stack cavity, size reduction and robustness may be increased at the same time.

In an embodiment, the thermal device comprises a base part that is embedded in stack material, e.g. in a core layer structure. In a further embodiment, the thermal device comprises a heat dissipation part (placed in the cavity), in particular connected to the base part. The heat dissipating part may comprise a variety of configurations, e.g. a block or a (plurality of) fin(s). The heat dissipating device may be a stand-alone device or directly manufactured on the stack (in particular on the base part).

According to an embodiment, the heat dissipation structure may be manufactured by plating (a metal material) in the cavity. The base part may serve as a seed layer to build-up heat dissipating structures such as plated copper pillars.

According to a further embodiment, the heat dissipation structure may be manufactured by additive manufacturing, in particular 3D-printing, in the cavity. In another example, the heat dissipation structure may be provided by subtractive manufacturing, e.g. etching or drilling (mechanically or laser) a (metal) structure in the cavity.

According to a further embodiment, the RF front-end functionality further comprises a power module assembled to the stack. In this context, the term "power module" may refer to a component/module configured to handle electric current that may be considered as comparably high with respect to other currents of the RF module. In an example, the power module may comprise a power amplifier.

According to a further embodiment, the thermal device is arranged to dissipate heat produced by the power module. The thermal device may be thermally coupled, in particular directly coupled, to one or more RF front-end functionality devices to dissipate heat of this/these. Since a power module is configured to handle (comparably) high currents, it may be advantageous to thermally couple the power module to the thermal device. In an embodiment, the power module is surface mounted or embedded at a first RF module main surface, while the thermal device may be arranged at a second, opposed main surface, thereby dissipating the heat produced by the power module through the stack. The described architecture may also be applied for the other devices of the RF front-end functionality.

According to a further embodiment, a thermal path between a heat-producing component and the thermal device is realized by a plurality of (copper) vias. Thereby, an efficient heat transportation may be realized by established PCB manufacture processes.

In an example, the power module and the thermal device are at least partially arranged on top of each other in the vertical direction (z), thereby enabling an especially short and efficient thermal path.

According to a further embodiment, the antenna structure and the cavity are formed at the same main surface of the stack. In this architecture, the power module and the antenna structure can be arranged at the opposed main surfaces. In an example, wherein the RF module is assembled to a further module, the antenna structure may be protected between both modules, while the power module may be fully exposed to dissipate heat to the environment efficiently.

In another embodiment, the antenna structure and the cavity are formed at different main surfaces of the stack. For example, the antenna structure may be arranged on the opposed main surface with respect to a further module. In an example, the antenna structure and the power module may both face away from the further module, thereby providing efficient heat dissipation and signal transm ission.

According to a further embodiment, the stack further comprises a (central) core layer structure. Such a core layer may provide stability to the RF module, in particular avoid warpage. Further, (electronic) components may be efficiently embedded in (cavities of) such a core layer. In an example, the core layer structure is based on resin, e.g. fully cured resin (FR4). In another example, the core layer structure may be at least partially configured as a glass substrate.

According to a further embodiment, the core layer structure is configured as a glass substrate. Such a glass-based layer structure may be robust and provide stability against warpage. Further, signal transmission quality may be increased by the glass material.

According to a further embodiment, the RF front-end functionality further comprises an electronic component and/or a filter device embedded in the stack. Components such as active or passive (electronic) components may be encapsulated in stack material, in particular in (a cavity of) a core layer structure of the stack. According to a further embodiment, the filter device is arranged in particular in the core layer structure of the stack, more in particular in a core cavity of the core layer structure.

According to a further embodiment, the filter device comprises a plurality of electrically conductive vias that vertically extend through a dielectric substrate, in particular the glass substrate. This may provide the advantage that a robust RF module can be provided, wherein an efficient and reliable filter can be realized without an electronic component, but by direct integration into the glass substrate.

According to an example, the replacement of the organic substrate with a glass substrate (core) may result in a lower warpage (bow and twist) of the module/package/substrate and increased rigidity. The glass substrate may further allow for the direct integration of filter elements in the module utilizing for example plated trough glass via technologies, therefore reducing supply chain complexity and increasing the RF performance.

According to a further embodiment, at least two components of the RF front-end functionality, in particular the embedded component and/or the filter device, are arranged at least partially in the vertical direction (z) below the antenna structure (along the stack thickness direction). In this manner, the architecture may be very compact and signal paths may be kept short (thereby more efficient and reliable). In a specific embodiment, the plurality of RF front-end functionality devices is embedded vertically below the antenna structure (at least partially aligned with the antenna structure in the vertical direction). In a further example, only the power module/amplifier may not be aligned in the vertical direction with the antenna structure.

According to a further embodiment, the stack further comprises a fluid (air) cavity arranged below, in particular directly below, the antenna structure. The stack (in particular electrically insulating material) comprises at least one air cavity below (directly below) the antenna structure. This may provide the advantage that the dielectric constant is increased for e.g. polymers as compared to air. Hence, air cavities may be preferably filled with air or another medium suitable for propagation of electromagnetic waves.

According to a further embodiment, there is described an RF arrangement, comprising:
i) an RF module as described above; and
ii) a further module (in particular comprising a baseband processor), e.g. a main module (such as a motherboard).

The RF module and the further module are stacked one above the other.

Hence, the RF module may be a versatile component that can be flexibly assembled to further electronic devices. In an example, the RF module comprises the RF front-end functionality, while the further module comprises further functionalities of the signal processing. In another example, the RF module comprises, besides the RF front-end functionality, further RF signal processing functionalities. In an example, the RF module does not comprise the baseband processor.

According to a further embodiment, the RF module and the further module are stacked so that the antenna structure of the RF module is oriented towards a main surface of the further module. In other words, the antenna structure may be arranged at a main surface (being perpendicular to the stacking direction, i.e. parallel to the x-y plane) of the RF module. In this configuration, the main surface of the RF module and the main surface of the further module may be opposed to each other, the antenna structure being in between. Thereby, the antenna structure may be efficiently protected, while signal transmission may still function in a reliable manner.

According to a further embodiment, the RF arrangement further comprises a spacer structure arranged between the RF module and the main module to thereby establish a space between the antenna structure and the main module main surface. This may provide the advantage that the space between the main surface of the RF module and the main surface of the further module is large enough to provide a cavity in between. This cavity may be a protection for the antenna structure, while the dimension of the cavity may be large enough to enable efficient signal transmission.

According to a further embodiment, the spacer structure comprises an electrically conductive structure, more in particular a solder ball. This may provide the advantage that an efficient and robust electrical connection between the RF module and the further module can be provided in a straightforward manner, using established manufacture processes. A solder ball may comprise a size large enough to provide a cavity with desirable dimensions. In another example, the electrically conductive spacer structure may be provided by a pad, a terminal, a pillar, a via, etc. In principle, every electrically conductive structure (in particular metal) may be suitable to provide the conductive spacer. Through the electrically conductive structure, the RF module may be connected to further RF circuitry of the further module, e.g. the baseband processor.

In an embodiment, the stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃). indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

### Brief Description of the Drawings

The aspects defined above and further aspects of the invention are apparent from the examples of embodiment to be described hereinafter and are explained with reference to these examples of embodiment.
Figure 1 illustrates an RF module according to an exemplary embodiment of the invention.
Figure 2 illustrates an RF module according to a further exemplary embodiment of the invention.
Figure 3 illustrates a front-end functionality according to an exemplary embodiment of the invention.
Figure 4 illustrates an RF arrangement with the RF module and a further module according to an exemplary embodiment of the invention.

### Detailed Description of the Drawings

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment, the RF module can comprise at least some of the following features:
i) antenna in or on substrate/package, ii) embedded switches, passives etc., iii) power amplifiers with integrated passive thermal management, iv) integrated electromagnetic interference (EMI) shielding of antenna layer, v) z-height reduction by using 2.5D technology and ferrite materials for shielding, vi) low warpage/highly rigid glass substrate, vii) direct filter integration in glass substrates.

According to an exemplary embodiment, there is described a highly integrated RF front-end module (antenna and RF front-end SiP (system-in-package)), e.g. for 5G radio applications. Through the usage of ECP technologies enough surface area on the package/substrate can be freed up to accommodate for an integrated high frequency antenna. The placement of active and passive components inside the package/substrate can improve signal quality as the signal path in the circuitry tends to be shorter and conventional solder joints can be e.g. replaced by plated copper connections. Furthermore, an integrated passive thermal management mainly for the power amplifier can be realized by embedding copper inlays which are connected to the power amplifier by copper plated/filled microvias. In addition, a cavity realized by cavity formation manufacture techniques, e.g. 2.5D technology. This can open up the area directly above the copper inlays to allow the direct placement of a heat sink which in turn leads to a reduction of the z-height (thickness) of the package. The layer construction of the package/substrate can be realized using laminates/materials with high magnetic permeability between the ECP package and the antenna layer for improved shielding against electromagnetic interference and again reduced z-height (thickness) of the package/substrate.

**Figure 1** illustrates an RF module 100 according to an exemplary embodiment of the invention. The RF module 100 is configured as a multi-layer printed circuit board (component carrier) that comprises a multi-layer stack 101 with electrically conductive layer structures 104 and electrically insulating layer structures 102. An RF front-end functionality 115 is integrated in the stack 101.

The RF front-end functionality 115 comprises a plurality of functionalities related to handling incoming/outgoing signals between antenna and a signal processor. In particular, the RF front-end functionality 115 can comprise, among others, the following functionalities: a filter functionality, an analog-to-digital conversion functionality, an antenna functionality, a switching functionality, a receiver functionality, a transmitter functionality, a transceiver functionality, an amplification functionality, in particular a low noise amplification and/or a power amplification.

An antenna structure 110 is assembled to the lower main surface of the RF module 100. In particular, the antenna structure 110 is directly surface mounted to the stack 101. The antenna structure 110 is configured as a patch antenna and is for example formed by structuring (e.g. etching) an electrically conductive layer structure on top of the stack 101. The antenna 110 can also be formed as a slot antenna (e.g. by placing a dielectric resonator antenna into a cavity of the component carrier) (not shown here). Adjacent (side-by-side) to the antenna structure 110, there is arranged a surface finish layer structure 105. Thereby, the antenna structure 110 is further mechanically protected.

An electromagnetic radiation shielding layer structure 160 is embedded in the stack 101, in this example below the antenna structure 110 (i.e. on top of each other in the vertical direction along z). The electromagnetic radiation shielding layer structure 160 extends in the horizontal direction along the whole length of the antenna structure 110 to enable an efficient shielding. The electromagnetic radiation shielding layer structure 160 is configured to shield electromagnetic radiation with respect to the antenna structure 110. Specifically, further RF front-end functionalities are protected by the shielding, in this example the filter device 130 and the RF transceiver 121. In an example, the the electromagnetic radiation shielding layer structure 160 comprises a magnetic material such as ferrite material. The electromagnetic radiation shielding layer structure 160 is not a continuous layer, but is intersected by vias 106 and a cavity 140 of the stack 101. Thus, the antenna structure 110 and the cavity 140 are formed at the same main surface of the stack 101. In a specific example, an air cavity is arranged directly below the antenna structure 110 in the stack 101 (not shown).

The cavity 140 is formed in the stack 101 between a core layer structure 103 and the lower main surface of the stack 101. A thermal device 145, configured as a heat dissipation structure, is completely placed into the cavity 140. The thermal device 145 is configured to dissipate heat from the RF front-end functionality 115, in this example from a power module 150 that is surface-mounted on the opposed upper main surface of the stack 101. The power module 150 is connected through the stack 101 to the thermal device 145 by a plurality of copper vias which are electrically and thermally conductive. The thermal device 145 is hereby arranged to dissipate heat produced by the power module 150 through a thermal path realized by the plurality of vias. The power module 150 and the thermal device 145 are at least partially arranged on top of each other in the vertical direction (z).

A base part of the thermal device 145 is embedded in a core cavity in the core layer structure 103, while heat-dissipating fin structures, directly connected with the base part, extend through the cavity 140 (in vertical (z) direction). In a preferred example, the heat-dissipating fins 146 have been arranged in the cavity 140 by plating.

The stack 101 further comprises the core layer structure 103, which is, in this particular example, realized as a glass substrate. Embedded in the core layer structure 103 is a filter device 130. The filter device 130 is realized by a plurality of electrically conductive vias 131 that vertically extend through the glass substrate 103.

The RF front-end functionality further comprises an embedded component 120, encapsulated in a core cavity of the core layer structure 103, adjacent to the filter device 130. In this example, the embedded component 120 is an amplifier, e.g. an LNA. The embedded component 120 and the filter device 130 are arranged in the vertical direction z below the antenna structure 110 with the electromagnetic radiation shielding layer structure 160 in between. It can be seen that the sidewalls of the cavity 140 taper at the bottom.

**Figure 2** illustrates an RF module 100 according to a further exemplary embodiment of the invention. This RF module 100 is very similar to the one described in detail for Figure 1. The first difference is that the filter is not implemented as a plurality of electrically conductive vias that are embedded in a glass substrate. Instead, the filter 130 in Figure 2 is implemented as an electronic component, embedded in the core layer structure 103, which is in this example a fully cured resin (e.g. FR4) layer structure. Further, the thermal device 145 in the cavity 140 does not comprise a plated heat-dissipating fin structures 146 as in Figure 1. Instead, a pre-fabricated heat removal structure is placed on the base part of the thermal device 145.

**Figure 3** illustrates a front-end functionality 115 according to an exemplary embodiment of the invention. While on the left side, there is shown a receiver path, a transmitter path is shown on the right side. In this example, the RF front-end functionality 115 comprises an antenna device 110, a switch and filter device 130, a power amplifier device 150, and a low noise amplification (LNA) device 120. The LNA device 120 and the power amplifier device 150 are both coupled to an RF transceiver device (processor) 121 that does not form part of the actual RF front-end functionality 115. The RF transceiver device 121 is coupled to a baseband processor 251 (signal processor) that is also not part of the RF front-end functionality 115. As shown in Figure 4 below, the baseband processor 251 can be outside the RF module 100, e.g. in a main module 250.

In the receiver path (left side), a signal is received at the antenna 110, filtered at the filter device 130, and amplified at the LNA device 120. Then, the signal, as received and processed by the RF front-end functionality 115, is further processed by the RF transceiver device 121 and the baseband processor 251.

In the transmitter path (right side), the signal originates from the baseband processor 251 and is transferred via the RF transceiver device 121 to the RF front-end functionality 115. The signal is amplified by the power amplifier 150 (instead of the LNA 120 in case of receiver path), filtered 130 and then transmitted via the antenna 110.

**Figure 4** illustrates an RF arrangement 200 with the RF module 100 and a further (main) module 250 according to an exemplary embodiment of the invention. In this example, the main module 250 is a component carrier that is configured as a mother board. The main module 250 comprises a baseband processor 251 that is coupled to the Rf front-end functionality. In the arrangement 200, the RF module 100 and the main module 250 are stacked one above the other, so that the antenna (layer) structure 110 of the RF module 100 is oriented towards a main surface 252 of the main module 250. In other words, the antenna structure 110 is arranged at the bottom main surface of the RF module 100. The main surface 252 of the main module 250 is in this case the upper main surface, which faces the antenna structure 110.

The RF arrangement 200 further comprises a spacer structure 210 arranged between the RF module 110 and the main module 250. The spacer structure 210 is hereby arranged adjacent (side-by-side) to the antenna structure 110, so that there is no disturbance of the later. Due to the spacer structure 210, there is a cavity (air gap) between antenna structure 110 and the upper main surface 252 of the main module 250. The spacer structure 210 is electrically conductive and in this example realized by solder balls. In this manner, there is at the same time provided electrical conductivity as well as sufficient space.

Through the electrically conductive spacer structure 210, the front-end functionality 115, in particular the transceiver, can be electrically connected with the baseband processor 251 of the main module 250.

### Reference signs

- 100: RF module, component carrier
- 101: Stack
- 102: Electrically insulating layer structure
- 103: Core layer structure, glass substrate
- 104: Electrically conductive layer structure
- 105: Surface finish layer structure
- 106: Via connection
- 110: Antenna structure
- 120: Embedded component, amplifier
- 121: RF transceiver device
- 130: Filter device
- 131: Via of filter device
- 140: Cavity
- 145: Thermal device
- 146: Plated heat sink fin
- 150: Power module, power amplifier
- 160: Electromagnetic radiation shielding layer structure, ferrite layer
- 200: Arrangement
- 210: Spacer structure, solder ball
- 250: Further module, main module, motherboard
- 251: Baseband processor
- 252: Main surface of main module

## Claims

1. A radio frequency, RF, module (100), comprising:
a stack (101) comprising at least one electrically conductive layer structure (104) and/or at least one electrically insulating layer structure (102); and
a RF front-end functionality (115) that is integrated in the stack (101).

2. The RF module (100) according to claim 1,
wherein the RF module (100) is configured as a printed circuit board, PCB, or as an integrated circuit, IC, substrate.

3. The RF module (100) according to claim 1 or 2,
wherein the RF front-end functionality (115) comprises at least two of: a filter functionality, an analog-to-digital conversion functionality, an antenna functionality, a switching functionality, a receiver functionality, a transmitter functionality, a transceiver functionality, an amplification functionality, in particular a low noise amplification, LNA, and/or a power amplification, an oscillator functionality, a mixer functionality.

4. The RF module (100) according to any one of the preceding claims, wherein the RF front-end functionality (115) further comprises:
an antenna structure (110) assembled, in particular surface mounted and/or embedded, at an outer surface, in particular an outer main surface, of the stack (101),
in particular wherein the antenna structure (110) is configured as a patch antenna.

5. The RF module (100) according to any one of the preceding claims, further comprising:
an electromagnetic radiation shielding layer structure (160) embedded in the stack (101),
in particular embedded below the antenna structure (110), and configured to shield electromagnetic radiation with respect to the antenna structure (110), more in particular wherein the electromagnetic radiation shielding layer structure (160) comprises a magnetic material, in particular a ferrite material.

6. The RF module (100) according to any one of the preceding claims, further comprising:
a cavity (140) in the stack (101), and
a thermal device (145), in particular a heat sink, arranged in the cavity (140), in particular completely arranged in the cavity (140), and configured to dissipate heat from at least a part of the RF front-end functionality (115), in particular wherein the RF front-end functionality (115) further comprises:
a power module (150) assembled to the stack (101),
wherein the thermal device (145) is arranged to dissipate heat produced by the power module (150),
in particular through a thermal path realized by a plurality of vias,
more in particular wherein the power module (150) and the thermal device (145) are at least partially arranged on top of each other in the vertical direction (z).

7. The RF module (100) according to any one of the preceding claims, wherein the antenna structure (110) and the cavity (140) are formed at the same main surface of the stack (101).

8. The RF module (100) according to any one of the preceding claims, wherein the stack (101) further comprises:
a core layer structure (103), in particular configured as a glass substrate.

9. The RF module (100) according to any one of the preceding claims, wherein the RF front-end functionality further comprises:
an electronic component (120) and/or a filter device (130) embedded in the stack (101), in particular in the core layer structure (103) of the stack (101),
more in particular in a core cavity of the core layer structure (103),
in particular wherein the filter device (130) comprises a plurality of electrically conductive vias (131) that vertically extend through a dielectric substrate, in particular the glass substrate (103).

10. The RF module (100) according to any one of the preceding claims,
wherein at least two components of the RF front-end functionality (115), in particular the embedded component (120) and/or the filter device (130), are arranged at least partially in the vertical direction (z) below the antenna structure (110); and/or
wherein the stack (101) further comprises:
a fluid cavity arranged below, in particular directly below, the antenna structure (110).

11. An RF arrangement (200), comprising:
an RF module (100) according to any one of the preceding claims; and
a further module (250), in particular comprising a baseband processor (251) ;
wherein the RF module (100) and the further module (250) are stacked one above the other.

12. The RF arrangement (200) according to claim 11,
wherein the RF module (100) and the further module (250) are stacked so that the antenna structure (110) of the RF module (100) is oriented towards a main surface (252) of the further module (250), and
wherein the RF arrangement (200) further comprises:
a spacer structure (210) arranged between the RF module (110) and the further module (250) to thereby establish a space between the antenna structure (110) and the further module main surface (252),
in particular wherein the spacer structure (210) comprises an electrically conductive structure, more in particular a solder ball.

13. A method of manufacturing a radio frequency, RF, module (100), the method comprising:
forming a stack (101), comprising at least one electrically conductive layer structure (104) and/or at least one electrically insulating layer structure (102); and
at least partially embedding a fully functional RF front-end functionality (115) into the stack (101).

14. The method according to claim 13, further comprising:
forming a cavity (140) in the stack (101); and
providing a thermal device (145) in the cavity (140),
in particular wherein providing the thermal device (145) comprises plating.

15. Using a component carrier (100), in particular a printed circuit board or an IC substrate, as a fully functional RF front-end module.
